# EUROPEAN PATENT APPLICATION

(11) **EP 2 930 736 A1**
(43) Date of publication of application: **14.10.2015**
(21) Application number: 14193311.9
(22) Date of filing: 14.11.2014
(51) Int. Cl.: H01J 37/20, H01J 37/285

(54) **Sample holding micro vice and sample holding system for coupled transmission electron microscopy (TEM) and atom-probe tomography (APT) analyses**

(30) Priority: 10.04.2014 EP 14305527
(71) Applicant: CENTRE NATIONAL DE LA RECHERCHE SCIENTIFIQUE, 75794 Paris Cedex 16 (FR); Aix-Marseille Université, 13284 Marseille Cedex 07 (FR)
(72) Inventor: Texier, Michaël, 13001 Marseille (FR); De Luca, Anthony, 13012 Marseille (FR); Portavoce, Alain, 13004 Marseille (FR); Furter, Jean-Jacques, 13003 Marseille (FR)
(74) Representative: Osha Liang

(57) **Abstract**

The present disclosure relates to a sample holding micro vice and a sample holding system for coupled transmission electron microscopy (TEM) and atom-probe tomography (APT) analyses. The sample holding micro vice (3) configured to support a tomographic TEM grid (2) intended to receive a sample (6), comprises a base (301) and a clamp. The base (301) comprises a mounting rod (302) configured to engage the sample holding micro vice (3) into the APT device; a base plate (314) fixed perpendicularly to the mounting rod (302); a flat part (303) disposed perpendicularly to the base plate (314) and on the base plate, said flat part (303) comprising a socket (306) having a shape complementary to the tomographic TEM grid (2) to receive the tomographic TEM grid (2) wherein the socket has a depth equal or less than the thickness of the tomographic TEM grid. The clamp (304) has a flat face (308) adapted to maintain the tomographic TEM grid (2) in the socket (306).

## Description

### TECHNICAL FIELD

The present disclosure relates to a sample holding micro vice and a sample holding system for coupled transmission electron microscopy (TEM) and atom-probe tomography (APT) analyses. Further, the present disclosure relates to a combined method for APT and TEM analyses.

### BACKGROUND

Atom probe tomography (APT) is a dedicated tool for the chemical characterization of samples at the nanometric scale. The principle is based on the evaporation of a tip-like shaped sample in an electric field, and rests on the analysis of the flight times of the evaporated atoms. This technique, which is destructive, provides chemical analysis of a small volume of material. It was initially limited to the study of conductive materials, but it has considerably grown in the recent years, mainly due to instrumental progresses that now allow applying the technique to semiconducting materials and oxides. Its scope of applications is very broad and covers the whole field of materials sciences such as microelectronics, optoelectronics, nanotechnology, thin films, *etc.* However, this technique is limited to the analysis of very small samples for which the specific geometry is dictated by the constraints of the evaporation technique. The preparation of the APT tip-like samples is complex and time-consuming. In addition, the correct interpretation of the data extracted from the APT analyses requires using adjustable parameters for data processing. For instance, erroneous estimation of the structural parameters of the studied sample can induce artefacts in the 3-dimensional reconstruction of the evaporated volume.

Transmission electron microscopy (TEM) provides a projected visualization of the object with an atomic spatial resolution. The transmission electron microscope operates on the same basic principles as an optical microscope but uses electrons instead of light. Thus, TEM is a microscopy technique in which a beam of electrons is transmitted through an ultra-thin sample, interacting with the sample as it passes through. An image is formed from the interaction of the electrons transmitted through the sample. Consequently the thickness of the specimen needs to be lower than a few hundreds of nanometres in the direction along the beam direction. This technique can provide many structural information of the sample with an unmatched spatial resolution. However, this technique is less sensitive to the chemistry of the sample than the APT technique and does not give direct 3-dimensional information of the studied volume.

The combination of both techniques allows exploiting their specific advantages. In particular, TEM imaging performed on a sample preliminary to its evaporation in APT, allows increasing the precision of adjustable parameters for APT data analysis. The chemical information given by the APT analysis can also be correlated to the structural information (presence of extended defects, crystallographic structure of nano-objects, *etc*.) provided by the TEM analysis. Thus, by coupling TEM and APT analyses on a same object, it becomes possible to obtain simultaneously structural and chemical information with an atomic spatial resolution.

US7759656 describes an assembly for holding a sample mounted on a TEM grid. In this document, the assembly allows the TEM grid to be easily transported by keeping the TEM grid safely into said assembly. Said assembly comprises two mating parts between which the TEM grid is secured, and a spring disposed around the two mating parts in order to compress the mating parts against each other and keep the TEM grid safely into the assembly.

Felfer et al. (see Reproducible Method for Damage-Free Site-Specific Preparation of Atom Prose Tips from Interfaces - Microscopy Research and technique 75:484-491 (2012)) describes a method to analyse a same sample with both techniques. For that purpose, a sample holding system is described that is designed to be inserted both in the TEM and in the APT device. This setup allows minimizing the risks linked to the manipulation of the sample as it is not necessary to remove the specimen from the holding system. However, it requires using a specific sample holder for TEM observations, *adapted to a specific TEM apparatus* which considerably reduces the available techniques that can be applied for analysing the sample. Accordingly, there exists a continuing need for developments for new sample holding systems. The present disclosure described hereafter is related to an improved sample holding system allowing an easy and safe manipulation of the TEM grid wherein a sample is mounted and analysed by coupled APT and TEM analysis.

### SUMMARY

An object of the present disclosure is to provide an improved sample holding system allowing an easy and safe manipulation of the sample analysed by coupled APT and TEM analyses.

According to a first aspect, the above-mentioned objects, as well as further advantages, are achieved by a sample holding micro vice configured to support a tomographic TEM grid intended to receive the sample. The sample holding micro vice comprises a base and a clamp. The base comprises a mounting rod configured to engage the sample holding micro vice into an APT device; a base plate fixed perpendicularly to the mounting rod; a flat part disposed on the base plate perpendicularly to the base plate, the flat part comprising a socket to receive the tomographic TEM grid having a shape complementary to the tomographic TEM grid. The socket of the flat part has a depth equal or less than a thickness of the tomographic TEM grid. The clamp of the sample holding micro vice is intended to be disposed on the base plate in front of the flat part and has a flat face adapted to maintain the tomographic TEM grid in the socket.

According to the present disclosure, the tomographic TEM grid may be any TEM grid. For example, the TEM grid may have standard dimensions and/or be any commercially available TEM grid such as a TEM grid made available from the company tedpella® (http://www.tedpella.com/grids_html/4510half.htm). For example, the TEM grid may comprise a support having a rounded edge and a straight edge and at least one micro tip post protruding from the straight edge and provided to receive the sample.

The socket allows holding the tomographic TEM grid and stabilizing the position of the tomographic TEM grid on the flat part. As the socket of the flat part has a depth equal or less than the thickness of the tomographic TEM grid, said tomographic TEM grid is laterally maintained by the clamp. Further, as the clamp is disposed on the base plate, said clamp may be taken away from the flat part, during handling, without any risk that the TEM grid falls. As a result, the manipulation of the tomographic TEM grid may be performed without risking damaging the sample, such as when a user opens or closes the clamp.

According to one or more embodiments, the depth of the socket may be equal to or lower than 50 µm, such as from 30 µm to 50µm.

According to one or more embodiments of the present disclosure, the clamp may comprise a hole drilled in a top edge of the clamp in order to manipulate easily the tomographic TEM Grid with, for example, a vacuum pickup system.

According to one or more embodiments of the present disclosure, the sample holding micro vice may further comprise at least one screw in order to assemble the clamp with the flat part.

According to one or more embodiments of the present disclosure, at least one spring may be inserted between the flat part and the clamp thereby providing facilitated insertion and removal of the tomographic TEM grid in the micro vice. For example, the spring may be configured to control the force applied by the clamp to the tomographic TEM grid. As the spring provides a predetermined force between the flat part and the clamp, a resistance is provided during screwing that avoids crushing the TEM grid and a restoring force is provided during unscrewing that allows releasing the TEM grid. In this way, the spring allows the clamp to be moved with respect to the base in a controlled manner. Also, in this way, the force exerted by the clamp on the TEM grid through the spring is applied with improved controlled. As a result, the TEM grid may be easily inserted and removed in the micro vice.

According to a second aspect, the present disclosure provides a sample holding system comprising the sample holding micro vice according to the first aspect and a tomographic TEM grid as disclosed therein. For example, the tomographic TEM grid may comprise a support having a rounded edge and a straight edge, wherein at least one micro-tip post is provided to receive the sample and to protrude from the straight edge.

In another aspect, the present disclosure provides a method for performing coupled TEM and APT analyses, the method comprising: attaching a sample to a tomographic TEM grid having a micro tip post; exposing the sample attached on the micro tip post of the tomographic TEM grid to a milling process so as to at least partially thin the sample; mounting the tomographic TEM grid with said sample within a TEM; operating the transmission electron microscopy so as to acquire structural information of the sample; mounting the tomographic TEM grid with said sample to a sample holding micro vice according to the first aspect wherein the sample holding micro vice is adapted to the tomographic TEM grid; mounting the sample holding micro vice within a chamber of an atom probe; operating the atom probe so as to cause evaporation of individual atoms at a tip of the sample; reconstructing volume evaporated based on the structural information of the sample obtained by TEM.

According to one or more embodiments of the present disclosure, attaching the sample to the tomographic TEM grid may be performed by gluing with a material, such as platinum, which allows a good electrical conductivity in the device.

According to one or more embodiments of the present disclosure, the milling process may comprise exposing the sample to a particle beam. According to these embodiments, the tip extremity is advantageously sharp enough to permit evaporation.

According to one or more embodiments of the present disclosure, the tomographic TEM grid is moved by suction from the TEM to the sample holding micro vice. According to these embodiments, the risk of damaging or dropping the sample is reduced.

Other aspects and advantages of the present disclosure will be apparent from the following Figures, description and appended claims.

### BRIEF DESCRIPTION OF THE DRAWINGS

- Figure 1A shows a front perspective view of a sample holding system according to the present disclosure;
- Figure 1B shows a sectional side view of a sample holding system according to the present disclosure, along the line AA of figure 1A;
- Figures 2A and 2B show schematic views of examples of standard tomographic TEM grids which may be inserted in the sample holding system according to the present disclosure;
- Figures 3A shows an exploded view of a sample holding micro vice according to one or more embodiments the present disclosure;
- Figure 3B and 3C show a front view of a base and a clamp of a sample holding micro vice according to the present disclosure;
- Figure 3D shows a top view of a sample holding micro vice according to one or more embodiments the present disclosure;
- Figure 4 shows a schematic view of a double-tilt TEM sample holder with a standard tomographic TEM grid;
- Figure 5A and 5B show schematic views of an APT sample holder of an APT device wherein a sample holding system according to the present disclosure may be emplaced;
- Figure 6 presents a diagram showing steps of a coupled APT and TEM analyses method according to the present disclosure;
- Figure 7 shows pictures of a sample fixed on a tomographic TEM grid according to the present disclosure;
- Figures 8A and 8B show TEM and SAT analyzes of a sample realized with a method according to the present disclosure.

### DETAILED DESCRIPTION OF EMBODIMENTS

Embodiments of the present disclosure will now be described in detail with reference to the accompanying figures. In the following detailed description of embodiments of the present disclosure, numerous specific details are set forth in order to provide a more thorough understanding of the present disclosure. However, it will be apparent to one of ordinary skilled in the art that the present disclosure may be practiced without these specific details. In other instances, well-known features have not been described in detail to avoid unnecessarily complicating the description.

Herein, the words "comprise/comprising" are synonymous with (means the same thing as) "include/including," "contain/containing", are inclusive or open-ended and do not exclude additional, unrecited elements. Further, herein the term "about" and "substantially" are synonymous with (means the same thing as) a 20% margin of the respective value.

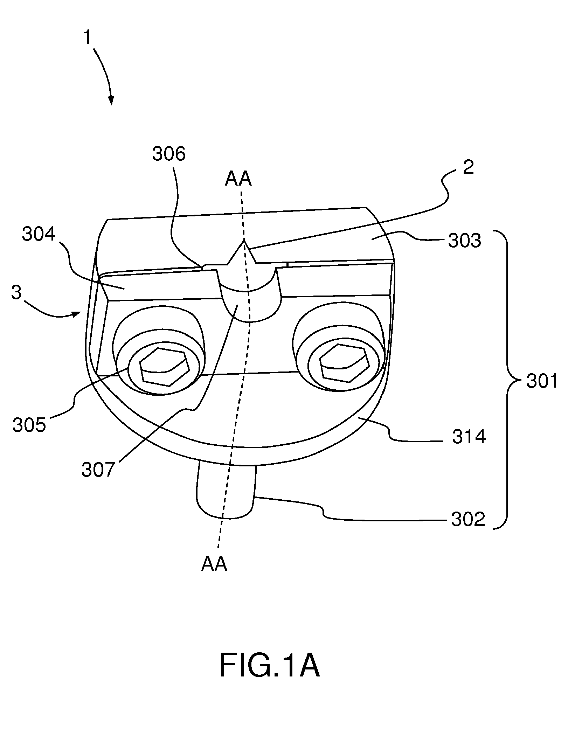

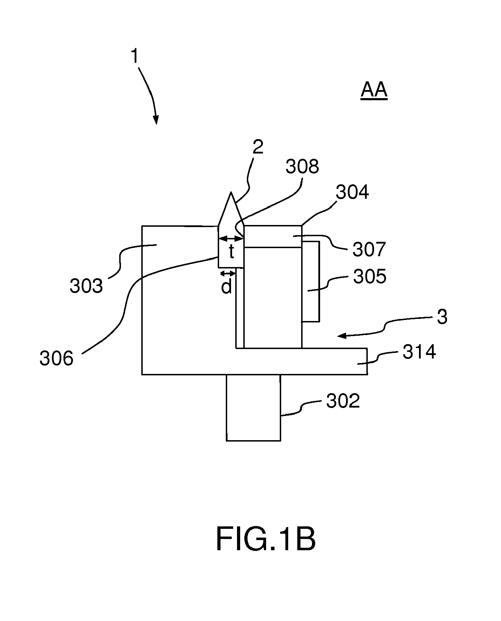

Figures 1A and 1B show schematic views of a sample holding system 1 according to the present disclosure. The sample holding system 1 comprises a sample holding micro vice 3 configured to support a tomographic TEM grid 2.

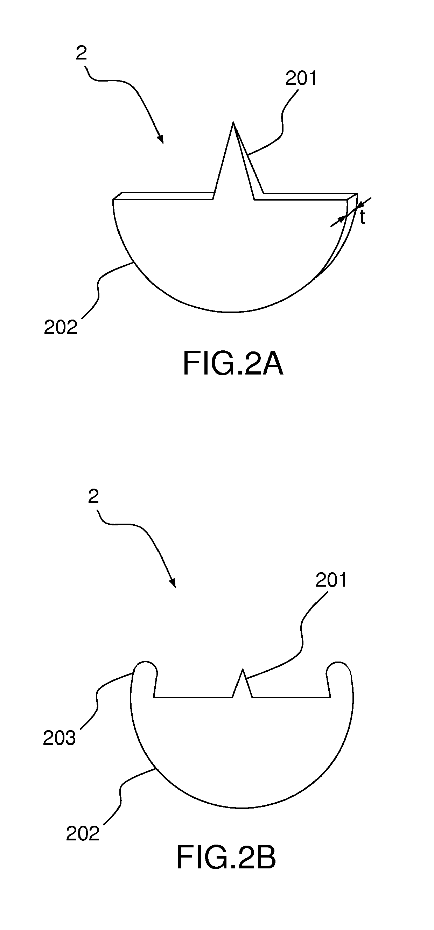

According to the present disclosure, the tomographic TEM grid may be any TEM grid. For example, the TEM grid may have standard dimensions and/or be any commercially available TEM grid such as a TEM grid made available from the company tedpella® (http://www.tedpella.com/grids_html/4510half.htm). For example, the TEM grid may comprise a support having a rounded edge and a straight edge and at least one micro tip post protruding from the straight edge and being provided to receive the sample. Typically the support may be circular with a diameter of about 3mm and a thickness between 50µm and 100µm. Figures 2A and 2B show schematic views of standard tomographic TEM grids 2. The tomographic TEM grid 2 comprises a support 202 and a micro tip post 201.

For example, the support 202 may have a rounded edge and a straight edge. In one or more embodiments, the rounded edge and the straight edge may define a portion of an elliptical or circular cylinder such as, for example, a half disk. For example, the length of the straight edge may be about 3mm. For example, the length of the straight edge may be the diameter of a half disk. In one or more embodiments, the tomographic TEM grid 2 is advantageously adapted to fit within a cradle of a standard TEM sample holder. Furthermore, according to these embodiments, the support 202 may comprise a wide planar surface adapted to be held by typical handling devices such as, for example, tweezers or vacuum pick up systems.

In addition, the micro tip post 201 may protrude from the straight edge. For example, the micro tip post 201 may be a sharpened part, such as a rectangular or square base pyramid or a cone, disposed at the center of the straight edge. In some embodiment, the extremity of the micro tip post 201 may be extremely thin such as, for example, from about 1 to about 2 micrometers thick.

The tomographic TEM grid may consist in one piece made with a material having a good thermal and electrical conductivity, a good mechanical strength, and a high evaporation temperature. According to these embodiments, cracking of the micro tip post 201 is advantageously avoided when an electric field is applied to a sample glued at the extremity of the micro tip post 201 during APT analysis. Further, the material of the tomographic TEM grid may be stable and inert under vacuum. In fact, the TEM grid should not degas under vacuum. For example, the tomographic TEM grid may be made of tungsten by stamping. The tungsten has a good thermal conductivity, a good electrical conductivity and mechanical strength. Also, tungsten has a high evaporation temperature and is stable and inert under vacuum.

In one or more embodiments, as illustrated in Fig. 2B, the tomographic TEM grid 2 may comprise at least one peripheral rung 203. For example, the peripheral rung 203 may be protruding at either end or at both ends of the straight edge. According to these embodiments, damage of the sample disposed on the tomographic TEM grid 2 is thus advantageously avoided during handling of said grid.

In one or more embodiments, the tomographic TEM grid 2 may be produced by stamping using, for example, a core drill or by cutting a foil of metal having for example, a thickness t ranging from about 50 to about 100 micrometres, which are standard dimensions. In one or more embodiments, thinning of the micro tip post 201 may be performed by Electrical Discharge Machining (EDM) by diving the sharpened part of the tomographic TEM grid 2 in a solution comprising an acid and/or an oxidant, for example, of about 25% perchloric acid and about 75% acetic acid and applying a voltage, for example, of about 20V and a current, for example, of about 20mA. According to these embodiments, tomographic TEM grid 2 comprising at least a micro tip post 201 having a sharp needle like extremity may advantageously be obtained. In one or more embodiments, the extremity of the micro tip post 201 may be further sharpened, for example, after EDM, by Focused Ion Beam (FIB) machining. For example, the micro tip post 201 may be sharpened using a high current ion beam, from various directions (e.g. front, back and side), such as by rotating the tomographic TEM grid 2. On further optional steps, annular patterns may be used in order to obtain an extremity having a substantially cylindrical or truncated conical shape. In one or more embodiments, micro tip post 201 may comprise a top flat surface disposed at the extremity. According to these embodiments, a sample may advantageously be disposed at the extremity of the micro tip post 201.

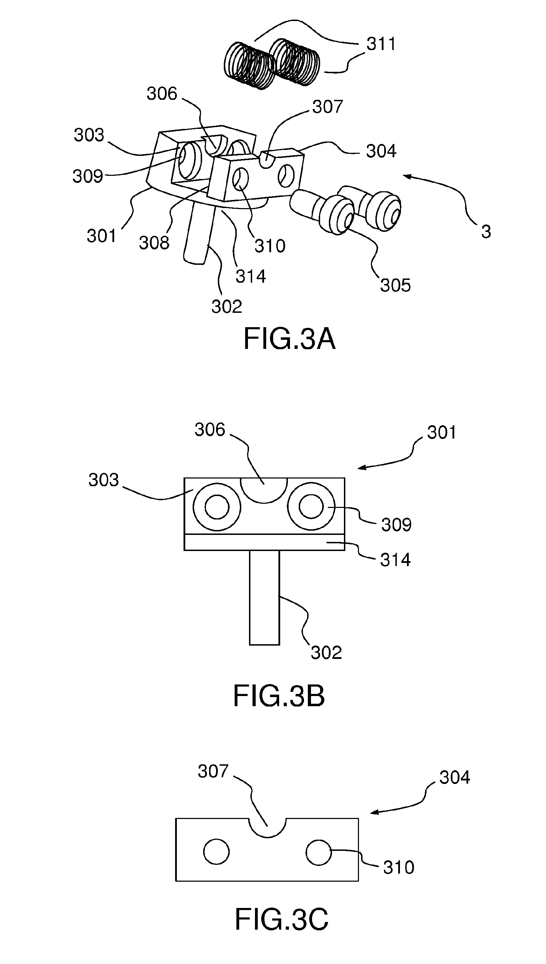

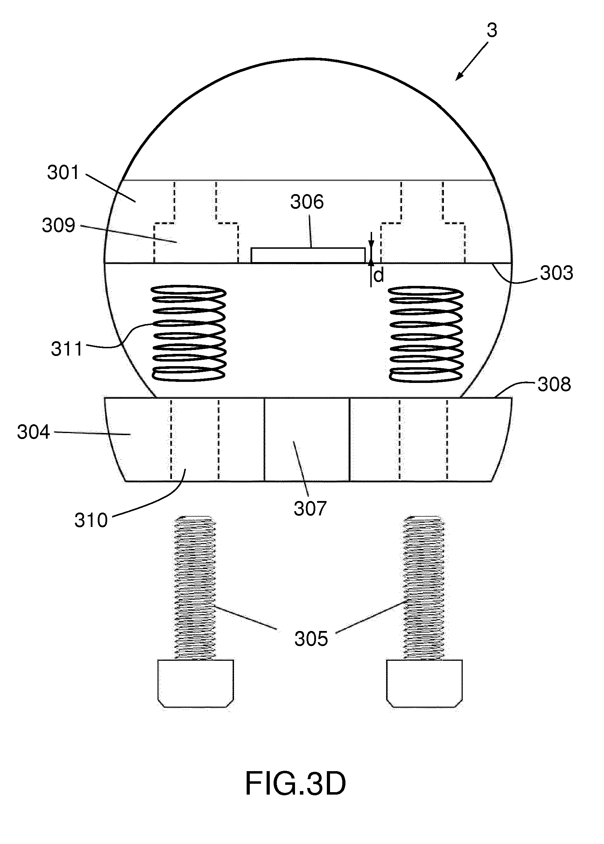

Figures 3A, 3B, 3C and 3D illustrate a sample holding micro vice 3 according to one or more embodiments of the present disclosure. For example, the sample holding micro vice 3 comprises a base 301 and a clamp 304, configured for mounting, easily removing and securing the tomographic TEM grid there between. As shown in figures 3A and 3B, the base 301 comprises a mounting rod 302, a base plate 314 fixed perpendicularly to the mounting rod 302 and a flat part 303 disposed perpendicular to the base plate 314 and on the base plate 314. In one or more embodiments, the base plate 314 and the flat part 303 may form an only piece. According to these embodiments, the mounting rod axis 302 allows the sample holding system 3 to be fit on an APT sample holder and/or on a (FIB) micromachining device. For example the diameter of the mounting rod may be smaller than about 2.5 mm such as, for example, about 1.9 mm.

In one or more embodiments, the flat part 303 comprises a socket 306 configured for holding the tomographic TEM grid 2 on the sample holding micro vice 3. The socket 306 has a shape which is complementary to the tomographic TEM grid 2. For example, the socket 306 may be circular with a diameter of about 3mm. In order to maintain the tomographic TEM grid in the socket, the depth d of the socket may be equal or less than the thickness t of the tomographic TEM grid. In view of the standard dimensions of used TEM grid, a depth of the socket comprised between 30 and 50 µm is adapted for maintaining tomographic TEM grid as described therein.

Figure 3C shows a schematic view of the clamp 304. Advantageously, the clamp 304 allows the tomographic TEM grid 2 to be secured within the sample holding micro vice 3. The clamp is provided to be placed on the base plate 314 and has a flat face 308 parallel to the flat part 303, this flat face being adapted for maintaining the tomographic TEM grid 2 in the socket 306.

In order to manipulate easily the tomographic TEM grid 2 with for example, a vacuum pickup system, a hole 307 may advantageously be drilled in the top edge of the clamp 304. On one hand, the diameter of the hole 307 may be large enough to insert a suction tool. On other hand, the diameter of the hole 307 may be small enough to ensure that a face 308 of the clamp 304 may be in contact with the tomographic TEM grid 2. In one or more embodiments, the diameter of the hole 307 may range from about 1.5 mm to about 2.5 mm such as, for example, about 2 mm.

In one or more embodiments, the clamp 304 may be fixed to the base with a securing device such as, for example, one or two screws 305, preferably two screws. In these embodiments, the clamp 304 may comprise at least one perforation 310, preferably two perforations 310, wherein a screw passes through to reach a corresponding threaded hole 309 positioned in the flat part 303.

As illustrated in figures 3A and 3D, in or more embodiments, one or more springs 311, preferably two springs, may be optionally inserted between the flat part 303 and the clamp 304. For example, one end of the spring 311 may be disposed into the entrance of the threaded hole 309 and the other end of the spring may be connected to the flat face 308 of the clamp 304. The screw 305 may be inserted into the perforation 310 of the clamp 304, through the spring, to connect the threaded hole 309 of the flat part 303 and to be screwed into said threaded hole 309, as illustrated figures 3A and 3D. According to these embodiments, insertion and removal of the tomographic TEM grid in the micro vice are thereby facilitated. For example, the spring may be configured to control the force applied by the clamp to the tomographic TEM grid.

In one or more embodiments, the sample holding micro vice 3 is made of metal having good thermal and electrical conductivities and being stable and inert under vacuum. According to these embodiments, the cooling of the sample is enhanced. Furthermore, according to these embodiments an electrical field between the sample and the local electrode may be applied. For example, the sample holding micro vice 3 may be made of aluminum.

According to one or more embodiments of the present disclosure, exemplary dimensions of the sample holding system are described below:
- the tomographic TEM grid 2 with a support may have a diameter of about 3mm and a thickness of about 100µm;
- the socket 306 of the flat part may have a depth of about 50µm and a diameter about 3,1mm; and/or
- the hole 307 of the clamp may have a diameter of about 2 mm.

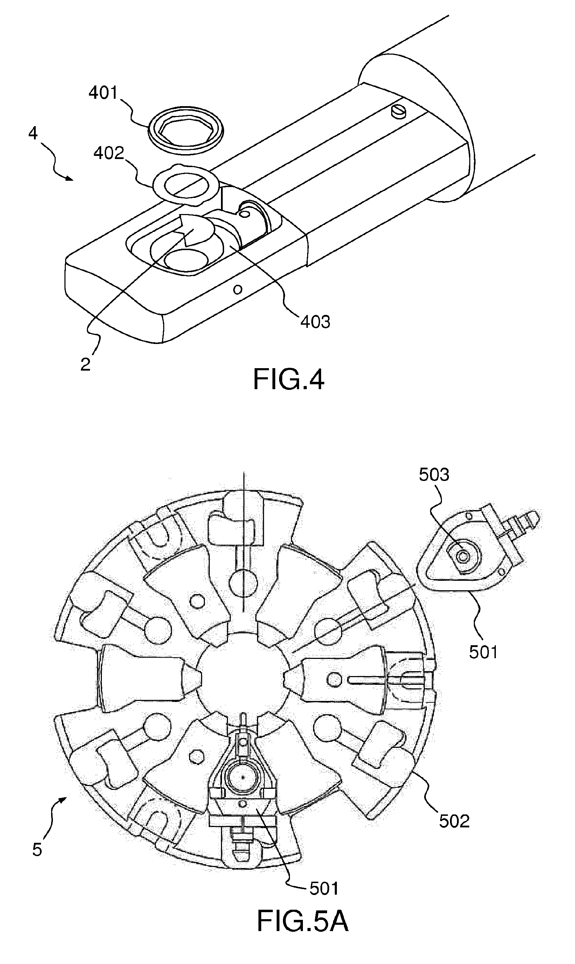

Figure 4 illustrates a schematic view of an exemplary double-tilt TEM sample holder 4 with a tomographic TEM grid according to the present disclosure (see Gatan Mod. 915). Advantageously, the tomographic TEM grid 2 is adapted to be placed between an anti-twist ring 402 and a cylindrical cradle 403 of the double-tilt TEM sample holder 4, using a second securing device such as screw 401.

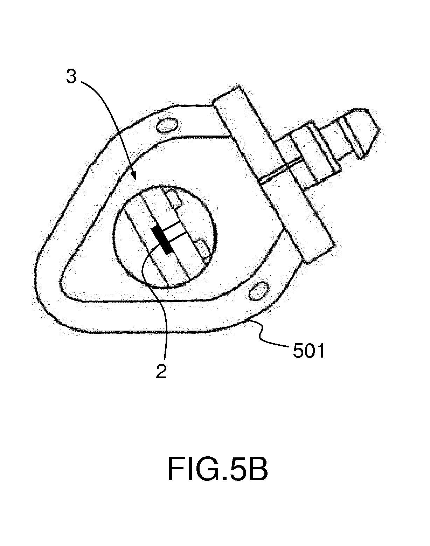

Figures 5A and 5B illustrate a schematic view of a standard APT sample holder of an APT device 5. Figure 5A has been extracted to the patent application US 20090138995 in order to explain where the sample holding system 1 according to the present disclosure may be emplaced in a standard APT sample holder. As illustrated figure 5B, in one or more embodiments, the sample holding micro vice 3 may be adapted to be placed in a vertical position in a puck 501 of the APT sample holder. In one or more embodiments, the mounting rod 302 may be adapted to fit inside a hole 503 having a diameter ranging from, for example, about 1.9 mm to about 2.5 mm. In one or more embodiments, the mounting rod may be secured within the APT sample holder with a third securing device such as a lateral screw. Furthermore, the puck 501 may be placed on a carousel 502 of the APT device thereby allowing the transfer of the sample into the APT analysis chamber using, for example, a transfer arm. Advantageously, in this way, the needle's extremity of the sample may be aimed towards an ion detector in the APT device.

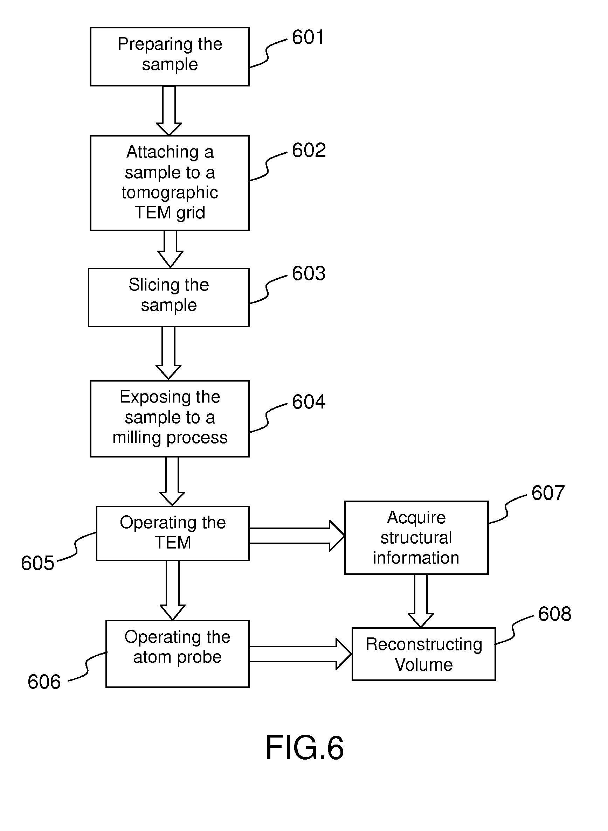

Figure 6 presents a diagram showing various steps of an example of a method to perform coupled TEM and APT analyses using a sample holding device according to one or more embodiments of the present disclosure. Although the below mentioned examples have been described in detail, it is understood that alternative embodiments of the disclosure can be envisaged.

The following steps may be performed under vacuum such as in a range of pressure below 10⁻⁶ Pa, for example.

The steps 601, 602, 603, 604 which are following, may be realized into the enclosure of a focused ion-beam device. So first of all, the sample holding device may be put into a focused ion-beam (FIB) machining device.

The method may comprise step 601. Step 601 comprises preparing the sample and milling around the region of interest. In one or more embodiments, the first step may comprise a lift-out process comprising defining and protecting a region of interest of a sample with a capping layer. For example, the capping layer may be provided in one and preferably two parts. For example, in one or more embodiments, a thin capping layer may be deposited onto the sample at a low of temperature. According these embodiments, sample modification during ion milling may advantageously be prevented. For example, the thin capping layer may be a layer comprising nickel and having a thickness of about 50 nm to about 100 nm. Furthermore, in one or more embodiments, a strip may be deposited over the region of interest. A strip is defined as a long, flat and narrow deposit. According to these embodiments, damage from the energetic ions used during sample preparation may advantageously be prevented to the near surface of the region of interest. For example, the strip may be made of platinum or tungsten. Once the region of interest is adequately protected, trenches may be milled by FIB around the region of interest coated by the stripe in order to form a wedge. So for example, step 601 may comprise other embodiments of sample preparation, which are known in the state of the art.

Step 602 comprises displacing the wedge or a sample using a tool such as a micromanipulator tool, and attaching the wedge or the sample to the micro tip post of a tomographic TEM grid of a sample holding device according to the present disclosure. For example, the wedge 701 may be aligned to the top of the micro tip post 201. According to these embodiments, a gap between the wedge and the micro tip post 201 may advantageously be filled in order to glue the wedge. According to these embodiments, the sample may be secured to the micro tip post by gluing the wedge on the extremity of the micro tip post, for example, with platinum deposit.

The method may comprise step 603. Step 603 comprises slicing the remaining wedge from the mounted sample by using Focused Ion Beam.

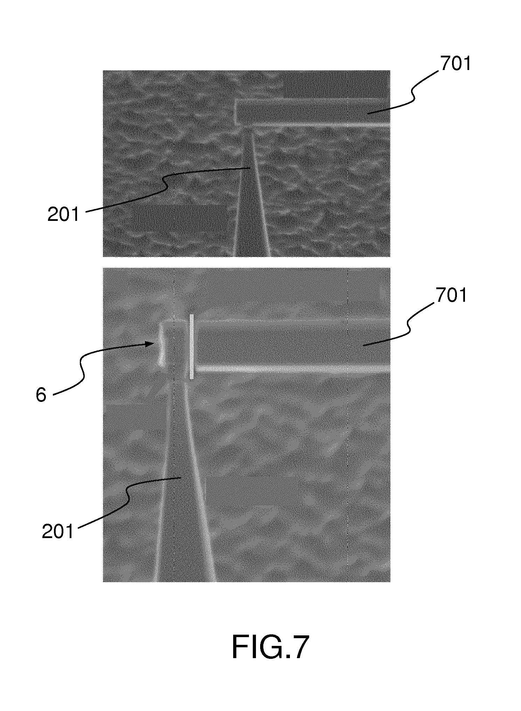

Steps 602 and 603 are illustrated on the figure 7. This figure is extracted to the article of Thompson et al ("In situ site-specific specimen preparation n for atoms probe tomography" Ultramicroscopy 107 (2007) 131-139*).* On the top figure, the sample wedge 701 is aligned to the micro tip post 201; on the bottom, at this point, Pt deposition is used to fill in the gap between the wedge 701 and the micro tip post 201. Once the wedge 701 is secure, the ion-beam is used to slice the remaining wedge 701 from the mounted sample 6, as illustrated on the bottom figures.

Step 604 comprises cutting the sample to obtain geometry of interest, such as exposing the sample by a milling process. In order to allow atom evaporation in the atomic probe tomography equipment, the sample may advantageously present a needle-like shape with optionally a curvature radius ranging from about 50 nm to about 100 nm. In order to obtain such needle-like shape, for example, the sample may be aligned with the ion column axis of the FIB machining device, and a first annular milling pattern may be used to obtain a cylinder-shaped portion of the sample having an inner diameter under an area of interest of the sample thinner than an outer diameter of the area of interest. For example, the inner diameter may be smaller than 5 µm. The larger outer diameter of the area of interest, however, may be larger than the inner diameter. For example the diameter of the area of interest may range from about 5-µm to about 10 µm. According to these embodiments, formation of sharp asperities on the micro tip post surface may advantageously be avoided. Further, according to one or more embodiments, the inner and outer diameters of the annular pattern may be reduced, as well as the ion current, in order to modify the shape from a cylinder to a cone. Further, strip may be removed. According to these embodiments, the tip extremity is advantageously sharp enough to permit evaporation.

According to this method, a sample fixed on a tomographic TEM grid and suitable for TEM and APT analyses is thereby obtained. Advantageously, the sample for TEM imaging is thin enough to be at least electron transparent. Moreover, depending on the nature of the studied material, on the accelerating voltage of the microscope and on the imaging technique used, the maximum thickness of the studied sample is advantageously as low as a few hundred or a few tens of nanometres. Also samples used in atom probe exhibit a needle geometry which may advantageously be placed in an ultra high vacuum chamber at very low temperature such as, for example, from about 20K to about 100K.

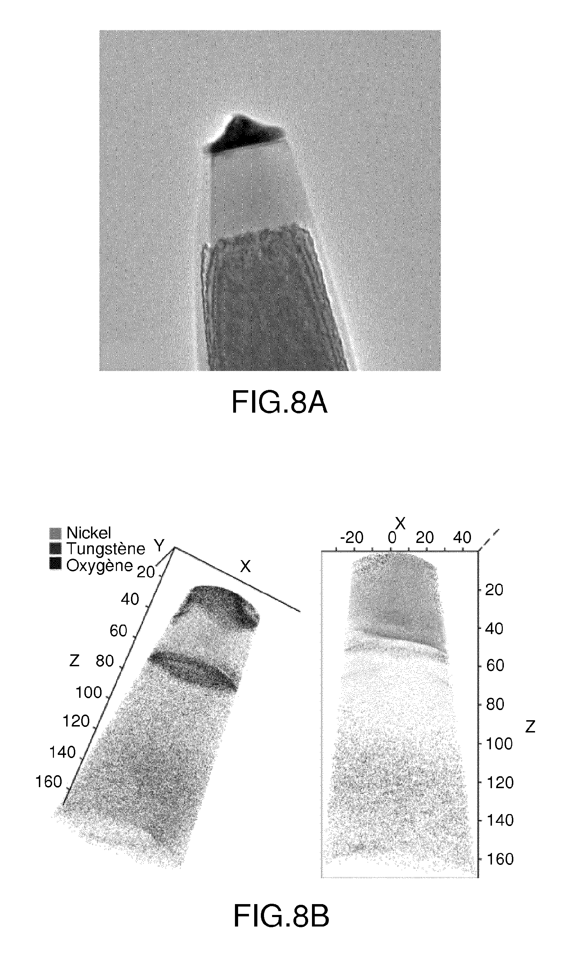

As APT analysis is destructive, samples are typically sublimated during analysis. Thus, according to one or more embodiments, the sample is necessary first analyzed by transmission electron microscopy, then by atom probe tomography. Step 605 comprises analyzing the sample by TEM. For that purpose, as illustrated on figure 4, the tomographic TEM grid 2 may be placed, for example, below the anti-twist ring 402 and maintained in the cylindrical cradle 403 using the screw 401. Further, the tomographic TEM grid may be manipulated by suction, for example by holding the support of the tomographic TEM grid 2 by using tools such as tweezers or vacuum pick up systems. Figure 7 picturing a sample 6 fixed on the tomographic TEM grid. Further, the transmission electron microscopy may be operated so as to acquire structural information (607) of the sample as shown on Figure 8A. Figure 8A is an example of the structural information obtained by TEM.

Step 606 comprises mounting the tomographic TEM grid with the sample to the micro vice of the sample holder system. In one or more embodiments, the tomographic TEM grid may be inserted into the circular socket of the flat part of the base of the micro vice. According to these embodiments, the position of the tomographic TEM grid into the micro vice is advantageously stabilized by the circular socket. The manipulation may be made with, for example, vacuum pickup systems. For example, the clamp 304 may be fixed to the base with two screws 305. Further, Step 606 also comprises mounting the sample holder system within a chamber of an atom probe and operating the atom probe so as to cause evaporation of individual atoms at a tip of the sample.

Step 608 comprises reconstructing volume evaporated based on the structural information of the sample obtained by TEM. Figure 8B illustrates results obtained by coupled TEM and APT analyses on an exemplary sample. More specifically, figure 8B shows a 3D reconstruction of the tip of the sample, different atomic species being represented by different grey colors (e.g. Nickel, Tungsten and Oxygen).

The method described below is usually used to prepare and analyse non-conductive samples for APT analyses using a focused ion beam (FIB) micromachining device. However it can be applied, in principle, to all types of inorganic materials and allows preparing samples from specific areas with a sub-micrometric precision.

While the method has been described with respect to a limited number of embodiments, those skilled in the art, having benefit of this disclosure, will appreciate that other embodiments can be devised which do not depart from the present disclosure.

The words used in the specification are words of description rather than limitation, and it is understood that various changes can be made without departing from the spirit and scope of the disclosure. As previously described, the features of various embodiments can be combined to form further embodiments of the present disclosure that may not be explicitly described or illustrated.

## Claims

1. A sample holding micro vice (3) configured to support a tomographic TEM grid (2) intended to receive a sample (6), comprising:
- a base (301) comprising:
- a mounting rod (302) configured to engage the sample holding micro vice (3) into an APT device;
- a base plate (314) fixed perpendicularly to the mounting rod (302);
- a flat part (303) disposed on the base plate (314), perpendicularly to said base plate wherein the flat part (303) comprises a socket (306) to receive the tomographic TEM grid (2), the socket (306) having a shape complementary to the tomographic TEM grid (2) and a depth equal or less than the thickness of the tomographic TEM grid; and
- a clamp (304) intended to be disposed on the base plate (314) in front of the flat part (303), said clamp having a flat face (308) adapted to maintain the tomographic TEM grid (2) in the socket (306).

2. The sample holding micro vice (3) according to claim 1, wherein the clamp (304) comprises a hole (307) drilled in a top edge of the clamp (304), configured to insert a suction tool.

3. The sample holding micro vice (3) according to claim 1 or 2, further comprising at least one screw (305) configured to assemble the clamp (304) with the flat part (303) of the base (301).

4. The sample holding micro vice according to claim 3, further comprising at least one spring (311) inserted between the flat part (303) of the base (301) and the clamp (304), said spring being configured to control a force applied by the clamp to the tomographic TEM grid (2)

5. The sample holding micro vice (3) according to any precedent claims, wherein the depth of the socket (306) is comprised between 30 µm and 50µm.

6. A sample holding system (1) comprising:
- the sample holding micro vice (3) according to any precedent claims; and
- at least one tomographic TEM grid (2).

7. The sample holding system (1) according to claim 6, wherein the tomographic TEM grid (2) comprises:
- a support (202) having a rounded edge and a straight edge; and
- at least one micro tip post (201) protruding from the straight edge and provided to receive the sample (6).

8. A method for performing coupled TEM and APT analyses, comprising:
- attaching (602) a sample (6) to a tomographic TEM grid having at least one micro tip post (201);
- exposing (604) the sample (6) attached on the micro tip post (201) of the tomographic TEM grid (2) to a milling process so as to at least partially thin the sample (6);
- mounting the tomographic TEM grid (2) with said sample (6) within a transmission electron microscopy (TEM);
- operating the TEM (605) so as to acquire structural information (607) of the sample (6);
- mounting the tomographic TEM grid (2) with said sample to the sample holding micro vice (3) according to any claims 1 to 5;
- mounting the sample holding micro vice (3)within a chamber of an atom probe (APT);
- operating the atom probe (606) so as to cause evaporation of individual atoms at a tip of the sample (6); and
- reconstructing volume (608) evaporated based on the structural information of the sample obtained by TEM.

9. The method for coupled TEM and APT analyses according to claim 8, wherein attaching the sample to the tomographic TEM grid is performed by gluing with platinum.

10. The method for coupled TEM and APT analyses according to any of claims 8 or 9, wherein the milling process comprises exposing the sample (6) to a particle beam.

11. The method for coupled TEM and APT analyses according to any of claims 8 to 10, wherein mounting the tomographic TEM grid (2) with the sample to the sample holding micro vice (3) is performed by moving the tomographic TEM grid by suction
